# EUROPEAN PATENT SPECIFICATION

(11) **EP 3 826 448 B1**
(45) Date of publication and mention of the grant of the patent: **26.07.2023**
(21) Application number: 18926443.5
(22) Date of filing: 20.07.2018
(51) Int. Cl.: H05K 13/04, H05K 13/08

(54) **COMPONENT MOUNTING MACHINE**
KOMPONENTENMONTAGEMASCHINE
MACHINE DE MONTAGE D'ÉLÉMENTS

(43) Date of publication of application: 26.05.2021
(73) Proprietor: Fuji Corporation, Chiryu-shi, Aichi 472-8686 (JP)
(72) Inventor: MIZUNO, Takayuki, Chiryu-shi, Aichi 472-8686 (JP); SENGA, Akihiro, Chiryu-shi, Aichi 472-8686 (JP)
(74) Representative: Grünecker Patent- und Rechtsanwälte PartG mbB
(86) International application number: PCT/JP2018/027281
(87) International publication number: WO 2020/017023

(56) References cited:
- WO-A1-2015/181898
- JP-A- 2012 248 626
- JP-A- 2015 090 925
- JP-A- 2017 084 931
- JP-A- 2017 162 845
- US-A- 5 369 493

## Description

### Technical Field

The present specification discloses a technique related to a component mounting machine that has a function of recognizing a character, a symbol, or a mark (hereinafter, referred to as a "recognition target") attached to an upper surface of a component supplied by a component supply device such as a tape feeder.

### Background Art

As a component mounting machine of this type, there is a component mounting machine, in which a mark imaging camera that images a board mark of a circuit board, on which a component is mounted, images a recognition target, such as a character and a mark, on an upper surface of the component supplied by a component supply device, such as a tape feeder, from above, and the image is processed to recognize the recognition target on the component upper surface, as described in Patent Literature 1 (JP-A-2004-356604). In this case, as a light source for imaging the recognition target on the component upper surface, a ring-shaped light source provided in the mark imaging camera is used.

However, since a lighting angle (the optical axis angle of a light beam) with respect to a recognition target, such as a character, on the component upper surface, is approximately 60° and a lighting angle suitable for recognizing the recognition target, such as a character, on the component upper surface, is larger than 10° to 45° in this configuration, it is difficult to recognize the recognition target, such as a character, on the component upper surface in some cases. In particular, in a case where the recognition target, such as a character, on the component upper surface, is engraved by a laser, when the lighting angle is large, there is almost no brightness difference between the recognition target and the component upper surface in the vicinity thereof, and the recognition target, such as a character, cannot be recognized at all.

Thus, as described in Patent Literature 2 (JP-A-2017-162845), there is a technique in which the number of lighting units of a mark imaging camera is increased to be on both sides in an X-direction, character recognition light sources are arranged on both outer sides of a general light source used in lighting a board mark, and in a case of recognizing a character on a component upper surface, by lighting the character on the component upper surface with the character recognition light sources positioned on both outer sides of the general light source, a lighting angle with respect to the character on the component upper surface is made small and the character on the component upper surface is imaged and recognized.

US 5 369 493 A discloses an apparatus for transporting an electronic component. The apparatus includes a movable head with a camera to determine the position of the electronic component relative to the head while the electronic component is being transported. A driving device moves an optical component relative to the camera. An illumination device illuminates the electronic component near the optical component or the nozzle.

### Patent Literature

Patent Literature 1: JP-A-2004-356604
Patent Literature 2: JP-A-2017-162845

### Summary of the Invention

### Technical Problem

However, since the character recognition light sources are arranged on both outer sides of the general light source used in lighting the board mark in the configuration of Patent Literature 2, the lighting units attached on a lower side of the mark imaging camera are configured to greatly overhang on both outer sides of the camera. In this case, since the mark imaging camera is attached to a mounting head and both are integrally moved during a component pickup and mounting operation, there is a possibility that the lighting units of the mark imaging camera, which moves integrally with the mounting head during the component pickup and mounting operation, interfere with an object existing in the vicinity thereof or a mounted component on a circuit board and thereby damage the object or the mounted component.

### Solution to Problem

The invention is defined by the features of independent claims 1 and 8. Further embodiments are defined in the dependent claims.

### Brief Description of Drawings

Fig. 1 is a side view showing a configuration of main sections of a component mounting machine of a first embodiment.
Fig. 2 is a broken perspective view of a lighting device, which is attached to an inner side of a front door of the component mounting machine, and an inside of the component mounting machine, in which an imaging position (lighting range) is viewed from an inner side of the component mounting machine.
Fig. 3 is a top view showing a positional relationship between a component pickup position of a tape feeder and the imaging position.
Fig. 4 is a block diagram showing a configuration of a control system of the component mounting machine.
Fig. 5 is a side view showing a configuration of main sections of a component mounting machine of a second embodiment.

### Description of Embodiments

Hereinafter, two first and second embodiments, which are disclosed in the present specification, will be described.

### First Embodiment

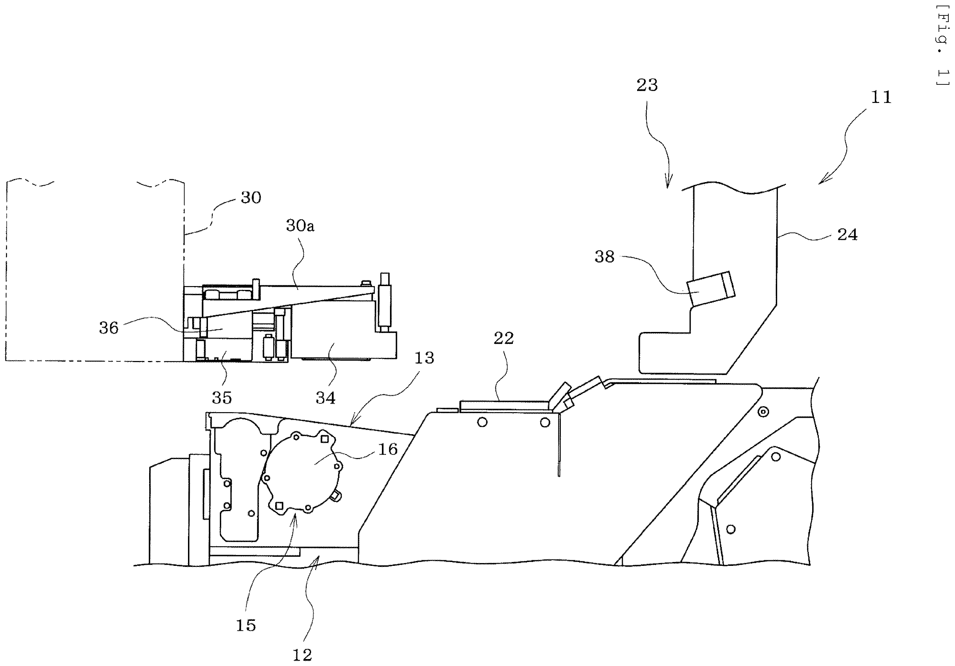

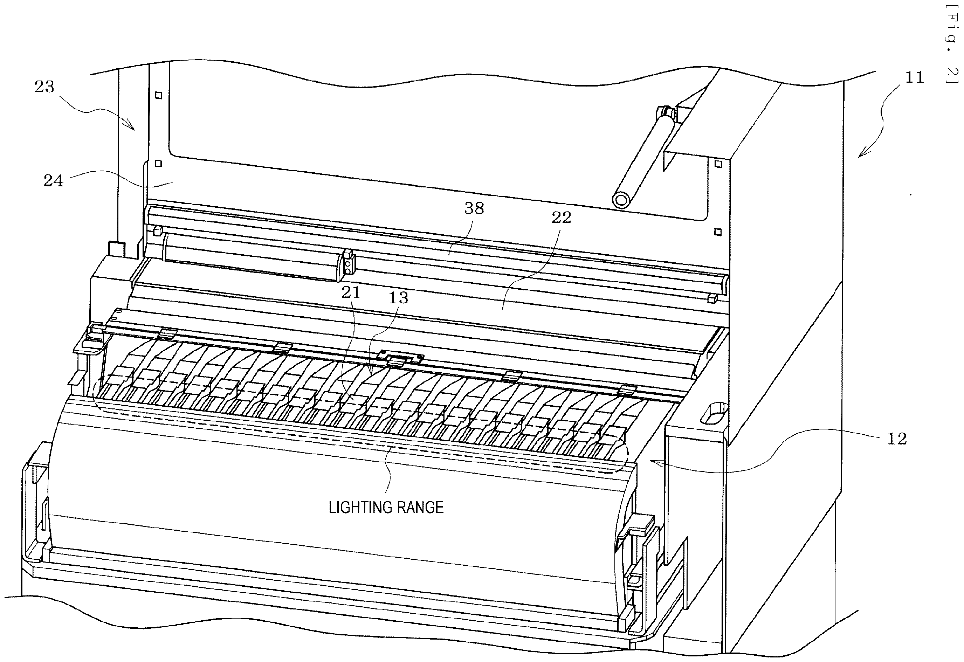

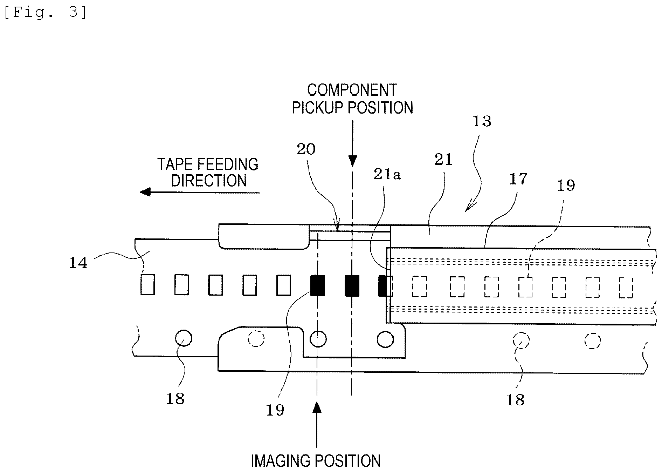

The first embodiment will be described based on Figs. 1 to 4. As shown in Figs. 1 and 2, multiple tape feeders 13 (component supply devices) are set on feeder setting section 12 provided on a front surface side of component mounting machine 11 so as to be detachable from the front surface side of component mounting machine 11. In each tape feeder 13, a tape reel (not shown), around which component supply tape 14 (see Fig. 3) is wound, is loaded, and tape feeding device 15, which pulls out component supply tape 14 from the tape reel and feeds the component supply tape to a component supply position pitch by pitch, is incorporated. Tape feeding device 15 is provided with a sprocket (not shown), of which a driving source is motor 16, and feeds component supply tape 14 pitch by pitch by meshing teeth of the sprocket with feed holes 18 (see Fig. 3) in component supply tape 14 and intermittently rotating the sprocket.

As shown in Fig. 3, tape passage 20, which is an upper end portion of each tape feeder 13 and through which component supply tape 14 passes, is provided with tape pressing cover 21 that presses the floating of component supply tape 14, which is fed to the component supply position pitch by pitch. Edge portion 21a of tape pressing cover 21 on a tape feeding direction side is positioned in front of a component pickup position; by hooking top tape 17 peeled from an upper surface of component supply tape 14 to edge portion 21a of tape pressing cover 21 on the tape feeding direction side and pulling the top tape with a top tape peeling mechanism (not shown) in an opposite direction to the tape feeding direction, top tape 17 is fed to the component pickup position pitch by pitch while being peeled from the upper surface of component supply tape 14 in front of the component pickup position to expose component 19 in component supply tape 14.

As shown in Figs. 1 and 2, feeder setting section 12 of component mounting machine 11 is provided with upper guide frame 22 that guides the insertion/removal of each tape feeder 13 in front-rear direction by restricting the movement of each tape feeder 13 in an up-down direction when attaching or detaching each tape feeder 13. A portion on the front surface side of component mounting machine 11, which is above upper guide frame 22, is front opening section 23 for maintenance, and front opening section 23 is opened and closed by front door 24.

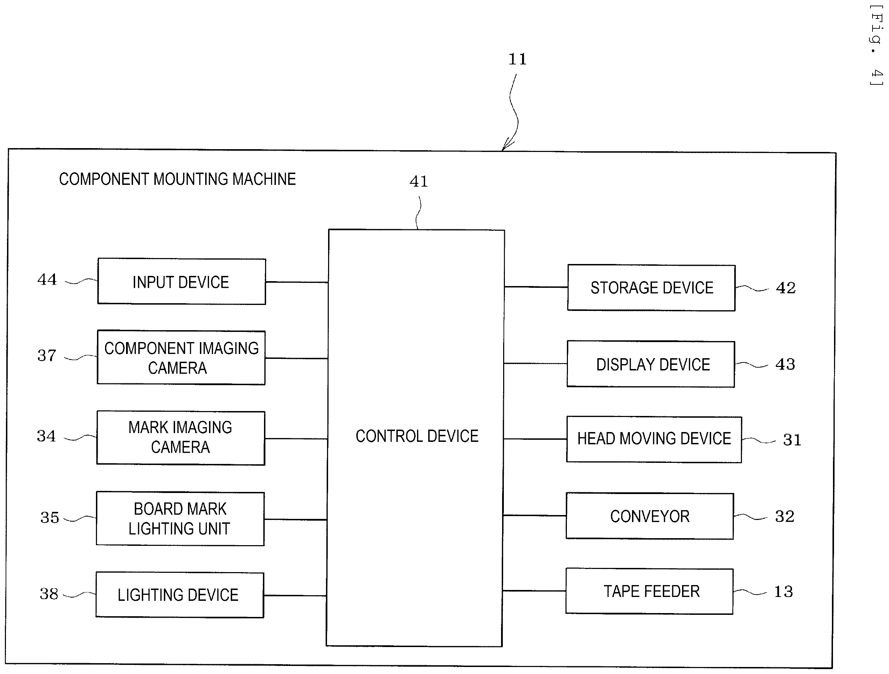

Inside component mounting machine 11, mounting head 30 that exchangeably holds a suction nozzle (not shown) picking up component 19 in component supply tape 14 at the component pickup position, which is at an upper end of tape feeder 13, head moving device 31 (see Fig. 4) that moves mounting head 30 in X- and Y-directions (right-left and front-rear directions), and conveyor 32 (see Fig. 4) that loads/unloads a circuit board (not shown) on which component 19 picked up by the suction nozzle of mounting head 30 is mounted are provided.

Mark imaging camera 34 that images a board mark (not shown) of a circuit board from above is attached to attachment frame 30a of mounting head 30, and mounting head 30 and mark imaging camera 34 are moved integrally with each other in the X- and Y-directions by head moving device 31. Mark imaging camera 34 is provided with ring-shaped board mark lighting unit 35 that illuminates the board mark from above when imaging the board mark of the circuit board, a prism that allows an image of the board mark to be formed on a light receiving surface of mark imaging camera 34, and optical system unit 36, such as a lens.

In addition, between tape feeder 13 set on feeder setting section 12 and conveyor 32, component imaging camera 37 (see Fig. 4) that images component 19 picked up by the suction nozzle of mounting head 30 from below is provided to face upward.

Further, in the first embodiment, lighting device 38 that illuminates a character, a symbol, or a mark (hereinafter, referred to as a "recognition target"), which is attached to an upper surface of component 19 in component supply tape 14 passing through tape passage 20 at the upper end of tape feeder 13, from obliquely above is attached to an inner side of front door 24 of component mounting machine 11. Lighting device 38 is configured by arranging multiple light emitting elements such as LEDs along a row of tape feeders 13 on feeder setting section 12. As shown in Fig. 2, lighting device 38 is configured to have substantially the same width dimension as the width dimension of feeder setting section 12 such that an imaging position to be described later, which is at the upper end of each of all tape feeders 13 set on feeder setting section 12, can be illuminated substantially uniformly from obliquely above.

In addition, in the first embodiment, the height position of lighting device 38 is set such that the lighting angle of the upper surface of component 19 positioned at the upper end of tape feeder 13 with respect to a recognition target (the optical axis angle of a light beam) is substantially 15°. In general, the lighting angle need only be set to fall within a range of 10° to 45°, more preferably within a range of 10° to 30°.

In addition, as shown in Fig. 4, component mounting machine 11 is provided with control device 41 that controls each function of component mounting machine 11, storage device 42 that stores various types of programs to be executed by control device 41 and various types of data, display device 43 that displays various types of information, and input device 44 such as a keyboard, a mouse, and a touch panel.

Control device 41 of component mounting machine 11 is configured mainly by one or multiple computers (CPU), controls an operation of loading/unloading a circuit board to and from conveyor 32, and controls a component pickup and mounting operation of picking up component 19 in component supply tape 14, that is fed pitch by pitch by tape feeder 13, with the suction nozzle of mounting head 30 and mounting the component on the circuit board.

Further, control device 41 of component mounting machine 11 controls an operation of imaging a board mark of a circuit board from above with mark imaging camera 34 and an operation of imaging component 19, which is picked up by the suction nozzle of mounting head 30, from below with component imaging camera 37, and also functions as an image processing device that recognizes a recognition target by processing an image captured by each of cameras 34 and 37.

In the first embodiment, mark imaging camera 34 is used also as a camera that images a recognition target, such as a character, which is attached to the upper surface of component 19 in component supply tape 14 positioned in tape passage 20 at the upper end of tape feeder 13, from above, in addition to imaging a board mark of a circuit board. When board mark lighting unit 35 provided in mark imaging camera 34 is used as a light source for imaging the recognition target on the upper surface of component 19 with mark imaging camera 34, the lighting angle of the upper surface of component 19 with respect to the recognition target is approximately 60°, which is larger than a lighting angle of 10° to 45° suitable for recognizing the recognition target on the upper surface of component 19; it is difficult to recognize the recognition target on the upper surface of component 19 in some cases.

Therefore, in the first embodiment, as the light source for imaging a recognition target on the upper surface of component 19 with mark imaging camera 34, lighting device 38 attached to the inner side of front door 24 of component mounting machine 11 is used. When the recognition target on the upper surface of component 19 positioned at the upper end of tape feeder 13 is illuminated by lighting device 38, it is possible for the lighting angle of the upper surface of component 19 with respect to the recognition target to fall within a range of 10° to 45°, more preferably, within a range of 10° to 30°, and thereby the recognition accuracy of the recognition target on the upper surface of component 19 can be improved.

It is necessary for the imaging position where a recognition target on the upper surface of component 19 in component supply tape 14 is imaged to be a position where top tape 17 is peeled from the upper surface of component supply tape 14 so that component 19 is exposed (a position on the tape feeding direction side from edge portion 21a of tape pressing cover 21 on the tape feeding direction side). Further, since tape pressing cover 21 presses the floating of component supply tape 14 passing through tape passage 20 at the upper end of tape feeder 13, when the imaging position is excessively close to the peeling position of top tape 17 (the position of edge portion 21a of tape pressing cover 21 on the tape feeding direction side), the light beam of lighting device 38 is blocked by tape pressing cover 21 so that the imaging position cannot be lit.

Therefore, in the first embodiment, the imaging position where a recognition target on the upper surface of component 19 in component supply tape 14 is imaged is set to a position separated by a predetermined distance in the tape feeding direction from the peeling position of top tape 17, that is, a position where a light beam, that is emitted from lighting device 38 toward the recognition target on the upper surface of component 19, is not blocked by tape pressing cover 21.

Since the component pickup position where he suction nozzle picks up component 19 in component supply tape 14 is positioned on the tape feeding direction side from the peeling position of top tape 17, the component pickup position may be the imaging position as it is insofar as a light beam from lighting device 38 can light the component pickup position without being blocked by tape pressing cover 21.

However, since the component pickup position is close to edge portion 21a of tape pressing cover 21 on the tape feeding direction side, in a case where the lighting angle of the upper surface of component 19 with respect to a recognition target is small, or a case where the thickness of tape pressing cover 21 is large, a light beam from lighting device 38 is blocked by tape pressing cover 21 in front of the component pickup position so that the component pickup position cannot be lit. In such a case, it is necessary to set the imaging position on the tape feeding direction side from the component pickup position.

The recognition of a recognition target on the upper surface of component 19 may be performed for all components 19 in component supply tape 14 loaded on tape feeder 13; however, in general, the recognition need only be performed once each time component supply tape 14 is loaded on tape feeder 13, each time tape feeder 13 is set on feeder setting section 12, or for each production change (for each changeover).

In addition, in a case where the imaging position is positioned on the tape feeding direction side from the component pickup position, control device 41 of component mounting machine 11 performs control such that component 19 at a leading end of component supply tape 14 loaded on tape feeder 13 is fed to the imaging position and is imaged by mark imaging camera 34 while a recognition target on the upper surface of component 19 is illuminated by lighting device 38 at the imaging position, and then component 19 at the leading end of component supply tape 14 is returned to the component pickup position so that component 19 is picked up by the suction nozzle. At this time, the lighting of the recognition target on the upper surface of component 19 at the imaging position by lighting device 38 need only be performed only during imaging by mark imaging camera 34, and lighting device 38 need only be turned off after imaging is finished.

Lighting device 38 may be turned on/off collectively at all light emission regions, or may be configured to be turned on/off independently at each light emission region when divided into multiple light emission regions. In the case of the latter, one or two or more light emission regions close to the position of a recognition target to be illuminated (the position of tape feeder 13) may be selected from multiple light emission regions so as to be turned on. In short, the recognition target to be imaged by mark imaging camera 34 need only be able to be uniformly lit.

Depending on the size of component 19, the position of a recognition target on the upper surface of component 19, the state of the recognition target, and the material for the upper surface of component 19, an optimum imaging position for recognition of the recognition target on the upper surface of component 19 differs in some cases.

In consideration of this point, in the first embodiment, data on an imaging position for each type of component 19 in component supply tape 14 is set in a production job (production program) or image processing component data. Image processing component data is data including the dimensions of each portion of component 19 used in image processing of component 19 picked up by the suction nozzle. Accordingly, in a case of recognizing a recognition target on the upper surface of component 19 in component supply tape 14, by imaging the recognition target on the upper surface of component 19 at the imaging position for each type of component 19 set in the production job or the image processing component data, control device 41 of component mounting machine 11 can recognize the recognition target on the upper surface of component 19 at an optimum imaging position in accordance with the type of component 19.

In addition, in a case where a recognition target on the upper surface of component 19 cannot be recognized, control device 41 of component mounting machine 11 performs control such that the imaging position is changed, component 19 at the leading end of component supply tape 14 is fed to the changed imaging position, and the recognition target on the upper surface of component 19 is again imaged at the changed imaging position by mark imaging camera 34 while being illuminated by lighting device 38 to perform image processing. Such a re-recognition operation is repeated until the successful recognition of the recognition target on the upper surface of component 19; in a case where the recognition target on the upper surface of component 19 cannot be recognized even when such a repeated number of times reaches a predetermined number of times, it is determined that some abnormalities have occurred and an error stop is performed.

In a case where a recognition target on the upper surface of component 19 cannot be recognized, the imaging position may be changed and the brightness of a light beam of lighting device 38 may be changed, or only the brightness of the light beam of lighting device 38 may be changed without changing the imaging position.

According to the first embodiment described hereinbefore, since lighting device 38 that illuminates a recognition target on the upper surface of component 19 positioned at the upper end of tape feeder 13 from obliquely above is attached to front door 24 of component mounting machine 11, lighting device 38 does not move even when mounting head 30 moves during the component pickup and mounting operation. For this reason, during the component pickup and mounting operation, lighting device 38 does not interfere with an object existing in the vicinity thereof or a mounted component on a circuit board. Moreover, since there are many spaces, which allows lighting device 38 to be attached, in front door 24, lighting device 38 can be attached at a height position where a lighting angle with respect to the recognition target on the upper surface of component 19 supplied by tape feeder 13 is an appropriate angle, and lighting suitable for recognizing the recognition target on the upper surface of component 19 can be achieved.

### Second Embodiment

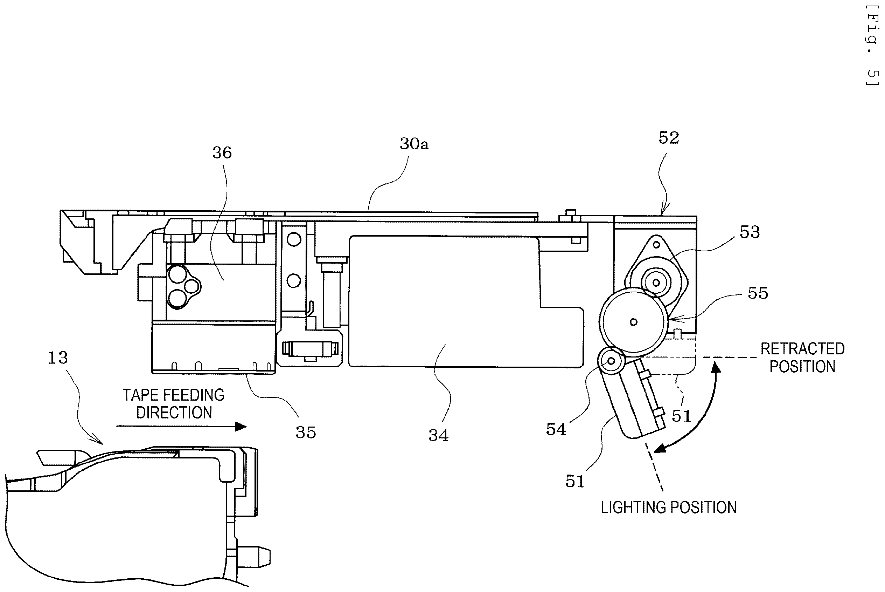

Next, the second embodiment will be described with reference to Fig. 5. However, the same reference signs will be assigned to substantially the same sections in the first embodiment, description thereof will be omitted or simplified, and mainly different sections will be described.

Lighting device 38 that illuminates a recognition target on the upper surface of component 19 from obliquely above is attached to front door 24 of component mounting machine 11 in the first embodiment; however, in the second embodiment shown in Fig. 5, lighting device 51 that illuminates the recognition target on the upper surface of component 19 from obliquely above is attached to attachment frame 30a of mounting head 30 together with mark imaging camera 34, and mounting head 30, mark imaging camera 34, and lighting device 51 are integrally moved by head moving device 31 in the X- and Y-directions.

Driving section 52 that revolves lighting device 51 is attached to attachment frame 30a of mounting head 30, and lighting device 51 is revolvably supported on a lower part side of driving section 52 via revolving shaft 54. Driving section 52 is configured to include motor 53, which is a driving source, and gear mechanism 55 which transmits the rotation of motor 53 to revolving shaft 54 of lighting device 51.

Lighting device 51 is revolvable between a lighting position where a recognition target on the upper surface of component 19 positioned at the imaging position at the upper end of tape feeder 13 is illuminated from obliquely above (the position of lighting device 51 shown with a solid line in Fig. 5) and a retracted position where lighting device 51 does not interfere with an object existing in the vicinity thereof or a mounted component on a circuit board when mounting head 30 performs the component pickup and mounting operation (the position of lighting device 51 shown with a two-dot chain line in Fig. 5). Further, in the second embodiment, there is a lighting angle adjusting function in which the lighting angle of lighting device 51 with respect to the recognition target on the upper surface of component 19 (the optical axis angle of a light beam) is adjusted by motor 53.

Lighting device 51 of the second embodiment need only be a small light source that can uniformly light, in a spot-targeting manner, an imaging range of mark imaging camera 34 that images a recognition target on the upper surface of component 19, and it is not necessary to use a large light source that can collectively light recognition targets of all tape feeders 13.

Further, a positional relationship between lighting device 51 and mark imaging camera 34 is configured such that when a position separated by a predetermined distance in the tape feeding direction from a position where top tape 17 of component supply tape 14 loaded on tape feeder 13 in feeder setting section 12 is peeled (the position of edge portion 21a of tape pressing cover 21 on the tape feeding direction side) is set as the imaging position and mark imaging camera 34 images a recognition target on the upper surface of component 19 at the imaging position, lighting device 51 is positioned on the tape feeding direction side from the imaging position, and the recognition target on the upper surface of component 19 at the imaging position is illuminated from obliquely above the tape feeding direction side. In this configuration, even when the imaging position is close to edge portion 21a of tape pressing cover 21 on the tape feeding direction side, the light beam of lighting device 51 can light the imaging position without being blocked by tape pressing cover 21. Therefore, the imaging position need only be the same position as the component pickup position. It is not necessary to perform a tape feeding/returning operation of component supply tape 14 for recognizing the recognition target on the upper surface of component 19 insofar as the imaging position is the same position as the component pickup position, and by that amount, time necessary for the recognition operation of the recognition target on the upper surface of component 19 can be shortened. However, the imaging position may be set to a position on the tape feeding direction side from the component pickup position.

In addition, the height position of lighting device 51 is set such that the lighting angle of the upper surface of component 19 with respect to a recognition target (the optical axis angle of a light beam) is substantially 15° in the second embodiment when mark imaging camera 34 images the recognition target on the upper surface of component 19 positioned at the upper end of tape feeder 13; however, in general, the lighting angle need only be set to fall within a range of 10° to 45°, more preferably, within a range of 10° to 30°.

In a case where mark imaging camera 34 images a recognition target on the upper surface of component 19 at the imaging position on tape feeder 13, control device 41 of component mounting machine 11 causes head moving device 31 to move mark imaging camera 34 to a position above the recognition target on the upper surface of component 19, causes motor 53 to rotate forward so that lighting device 51 revolves to the lighting position, and causes mark imaging camera 34 to image the recognition target on the upper surface of component 19 while the recognition target on the upper surface of component 19 is illuminated from obliquely above as lighting device 51 is turned on. After imaging is finished, lighting device 38 is turned off, motor 53 is rotated reversely to revolve lighting device 51 to the retracted position, and lighting device 51 does not interfere with an object existing in the vicinity thereof and a mounted component on a circuit board when mounting head 30 performs the component pickup and mounting operation.

Further, in a case where a recognition target on the upper surface of component 19 cannot be recognized, control device 41 of component mounting machine 11 changes the lighting angle of lighting device 51 such that the recognition target on the upper surface of component 19 is again imaged and image processing is performed. Such a re-recognition operation is repeated until the successful recognition of the recognition target on the upper surface of component 19; in a case where the recognition target on the upper surface of component 19 cannot be recognized even when such a repeated number of times reaches a predetermined number of times, it is determined that some abnormalities have occurred and an error stop is performed.

In a case where a recognition target on the upper surface of component 19 cannot be recognized, the lighting angle of lighting device 51 may be changed and the brightness of a light beam of lighting device 38 may be changed, or only the brightness of a light beam of lighting device 38 may be changed without changing the lighting angle of lighting device 51.

The same effects as in claim 1 can be obtained also in the second embodiment described above.

In the second embodiment, the positional relationship between lighting device 51 and mark imaging camera 34 is described such that when mark imaging camera 34 images a recognition target on the upper surface of component 19 at the imaging position, lighting device 51 is positioned on the tape feeding direction side from the imaging position so that the recognition target on the upper surface of component 19 at the imaging position is illuminated from obliquely above the tape feeding direction side; however, lighting device 51 may be disposed in a direction different therefrom, and the recognition target on the upper surface of component 19 may be illuminated from obliquely above a different direction. In short, lighting device 51 need only be disposed such that the lighting angle of the upper surface of component 19 with respect to the recognition target is within a range of 10° to 45°. In addition, the attachment structure of lighting device 51 may also be changed, and lighting device 51 need only be provided to move integrally with mounting head 30.

In addition, lighting device 51 is configured to be revolved between the lighting position and the retracted position in the second embodiment; however, lighting device 51 may also be configured to be moved between the lighting position and the retracted position. In short, lighting device 51 need only be moved or revolved with a position where lighting device 51 does not interfere with an object existing in the vicinity thereof and a mounted component on the circuit board, when mounting head 30 performs the component pickup and mounting operation, as the retracted position.

A recognition target on the upper surface of component 19 supplied by tape feeder 13 is recognized in the first and second embodiments; however, a component supply device other than the tape feeder (for example, a tray feeder and a stick feeder) may recognize the recognition target on the upper surface of the supplied component.

In addition, the present invention is not limited to the first and second embodiments; it is evident that the present invention can be realized with various changes made within the limits of the appended claims.

### Reference Signs List

11... component mounting machine, 12... feeder setting section, 13... tape feeder (component supply device), 14... component supply tape, 15... tape feeding device, 17... top tape, 19... component, 20... tape passage, 21... tape pressing cover, 23... front opening section, 24... front door, 30... mounting head, 31... head moving device, 34... mark imaging camera, 35... board mark lighting unit, 38... lighting device, 41... control device (image processing device), 51... lighting device, 52... driving section, 53... motor, 55... gear mechanism

## Claims

1. A component mounting machine (11) having a function of recognizing a recognition target, comprising a character, a symbol, or a mark, attached to an upper surface of a component (19) supplied by a component supply device (13), the component mounting machine (11) comprising:
a lighting device (38) configured to illuminate the recognition target on the upper surface of the component (19) supplied by the component supply device (13), when the recognition target is positioned at an upper end of a feeder (13), from obliquely above;
a front door (24) positioned above the feeder (13) configured to open and close a front opening section (23) in the component mounting machine (11)
a camera (34) configured to image the recognition target on the upper surface of the component (19), which is illuminated by the lighting device (38) from obliquely above, from above; and
an image processing device (41) configured to process an image captured by the camera (34) to recognize the recognition target,
wherein the lighting device (38) is attached to the front door (24).

2. The component mounting machine (11) according to claim 1, wherein the camera (34) is a mark imaging camera configured to image a board mark of a circuit board on which the component (19) is mounted.

3. The component mounting machine (11) according to claim 1 or 2, wherein the component supply device (13) is a tape feeder set on a feeder setting section (12) provided in the component mounting machine (11), the front door (24) is positioned above the tape feeder set on the feeder setting section (12), the lighting device (38) illuminates a recognition target on the component upper surface at the imaging position, the imaging position being a position separated by a predetermined distance in a tape feeding direction from a position where a top tape (17) of a component supply tape (14) loaded on the tape feeder (13) set on the feeder setting section (12) is peeled, and the camera (34) images the recognition target on the component upper surface at the imaging position.

4. The component mounting machine (11) according to claim 3, wherein the imaging position is positioned on a tape feeding direction side from a component pickup position where a suction nozzle picks up the component (19) in the component supply tape (14).

5. The component mounting machine (11) according to claim 4, wherein the imaging position is set in a production job or image processing component data for each type of component in the component supply tape (14).

6. The component mounting machine (11) according to claim 4 or 5, wherein in a case of recognizing the recognition target on the component upper surface in the component supply tape (14), a control device configured to control a tape feeding operation of the component supply tape (14) of the tape feeder (13) performs control such that the component (19) at a leading end of the component supply tape (14) is fed to the imaging position to image the recognition target on the component upper surface at the imaging position, and then the component (19) at the leading end of the component supply tape (14) is returned to the component pickup position to pick up the component (19) with the suction nozzle.

7. The component mounting machine (11) according to claim 6, wherein in a case where the image processing device (41) is not able to recognize the recognition target on the component upper surface, the control device performs control such that the imaging position is changed, the component (19) at the leading end of the component supply tape (14) is fed to the changed imaging position, and the recognition target on the component upper surface is again imaged at the changed imaging position to perform image processing.

8. A component mounting machine (11) comprising:
a mounting head (30) configured to mount a component (19) supplied by a component supply device (13) on a circuit board;
a mark imaging camera (34) provided to move integrally with the mounting head (30) and configured to image a board mark of the circuit board;
an image processing device (41) configured to process an image captured by the mark imaging camera (34); and
a lighting device (51) configured to illuminate a recognition target, comprising a character, a symbol, or a mark, attached to an upper surface of the component (19) supplied by the component supply device (13), when the recognition target is positioned at an upper end of a feeder (13), from obliquely above,
the component mounting machine (11) being configured to:
image the recognition target on the component upper surface, which is illuminated by the lighting device (51) from obliquely above, from above with the mark imaging camera (34), and
process the image with the image processing device (41) to recognize the recognition target,
wherein the lighting device (51) is provided to move integrally with the mounting head (30) and includes a driving section (52) attached to the mounting head (30) and is configured to:
move or revolve the lighting device (51) separately from the mounting head (30), and
when the mark imaging camera (34) images the recognition target on the component upper surface, move or revolve the lighting device (51) to a lighting position where the recognition target is illuminated from obliquely above, and
when the mounting head (30) performs a component (19) pickup and mounting operation, move or revolve the lighting device (51) to a retracted position where the lighting device (51) does not interfere with an object existing in a vicinity thereof or a mounted component (19) on the circuit board.

9. The component mounting machine (11) according to claim 8, wherein the component supply device (13) is a tape feeder set on a feeder setting section (12) provided in the component mounting machine (11), and a positional relationship between the lighting device (51) and the mark imaging camera (34) is configured such that when the mark imaging camera (34) images the recognition target on the component upper surface at an imaging position which is a position separated by a predetermined distance in a tape feeding direction from a position where a top tape (17) of a component supply tape (14) loaded on the tape feeder set on the feeder setting section (12) is peeled, the lighting device (51) is positioned on a tape feeding direction side from the imaging position, and the recognition target on the component upper surface at the imaging position is illuminated from obliquely above the tape feeding direction side.

10. The component mounting machine (11) according claim 8 or 9, wherein the driving section (52) has a function of adjusting a lighting angle of the lighting device (51) with respect to the recognition target on the component upper surface.

11. The component mounting machine (11) according claim 10, wherein in a case where the image processing device (41) is not able to recognize the recognition target on the component upper surface, the driving section (52) changes the lighting angle of the lighting device (51) such that the recognition target on the component upper surface is again imaged and image processing is performed.

## Patentansprüche

1. Bauteilbestückungsmaschine (11) mit einer Funktion zum Erkennen eines Erkennungsziels, das ein Zeichen, ein Symbol oder eine Markierung umfasst und an einer oberen Fläche eines Bauteils (19) angebracht ist, das von einer Bauteilzuführungsvorrichtung (13) zugeführt wird, wobei die Bauteilbestückungsmaschine (11) umfasst:
eine Beleuchtungsvorrichtung (38), die so konfiguriert ist, dass sie das Erkennungsziel auf der Oberseite des von der Bauteilzuführvorrichtung (13) zugeführten Bauteils (19) von schräg oben beleuchtet;
eine Vordertür (24), die oberhalb der Bauteilzuführvorrichtung (13) angeordnet und so konfiguriert ist, dass sie einen vorderen Öffnungsabschnitt (23) in der Bauteilbestückungsmaschine (11) öffnet und schließt;
eine Kamera (34), die so konfiguriert ist, dass sie das Erkennungsziel auf der Oberseite des Bauteils (19), das von der Beleuchtungsvorrichtung (38) von schräg oben beleuchtet wird, von oben abbildet; und
eine Bildverarbeitungsvorrichtung (41), die so konfiguriert ist, dass sie ein von der Kamera (34) aufgenommenes Bild verarbeitet, um das Erkennungsziel zu erkennen,
wobei die Beleuchtungseinrichtung (38) an der Vordertür (24) angebracht ist.

2. Bauteilmontagemaschine (11) nach Anspruch 1, wobei die Kamera (34) eine Markierungsabbildungskamera ist, die so konfiguriert ist, dass sie eine Leiterplattenmarkierung einer Leiterplatte abbildet, auf der das Bauteil (19) montiert ist.

3. Bauteilbestückungsmaschine (11) nach Anspruch 1 oder 2, wobei die Bauteilzuführeinrichtung (13) eine Bandzuführeinrichtung ist, die auf einem in der Bauteilbestückungsmaschine (11) vorgesehenen Zuführungseinstellabschnitt (12) angeordnet ist, die Fronttür (24) oberhalb der auf dem Zuführungseinstellabschnitt (12) angeordneten Bandzuführeinrichtung positioniert ist, die Beleuchtungseinrichtung (38) ein Erkennungsziel auf der Bauteiloberseite an der Abbildungsposition beleuchtet, die Abbildungsposition eine Position ist, die durch einen vorbestimmten Abstand in einer Bandzuführungsrichtung von einer Position getrennt ist, an der ein oberes Band (17) eines Bauteilzuführungsbandes (14), das in die Bandzuführung (13) geladen ist, die auf den Zuführungseinstellabschnitt (12) gesetzt ist, abgezogen wird, und die Kamera (34) das Erkennungsziel auf der Bauteiloberseite an der Abbildungsposition abbildet.

4. Bauteilbestückungsmaschine (11) nach Anspruch 3, wobei die Abbildungsposition auf einer Seite der Bandzuführungsrichtung von einer Bauteilaufnahmeposition positioniert ist, wo eine Saugdüse das Bauteil (19) in dem Bauteilzuführungsband (14) aufnimmt.

5. Bauteilbestückungsmaschine (11) nach Anspruch 4, wobei die Abbildungsposition in einem Produktionsauftrag oder in Bildverarbeitungs-Bauteildaten für jeden Bauteiltyp im Bauteilvorratsband (14) festgelegt ist.

6. Bauteilbestückungsmaschine (11) nach Anspruch 4 oder 5, wobei im Falle des Erkennens des Erkennungsziels auf der Bauteiloberseite im Bauteilzuführband (14) eine Steuervorrichtung, die so konfiguriert ist, dass sie einen Bandzuführungsvorgang des Bauteilzuführungsbandes (14) der Bandzuführung (13) steuert, eine solche Steuerung durchführt, dass das Bauteil (19) an einem vorderen Ende des Bauteilzuführungsbandes (14) der Abbildungsposition zugeführt wird, um das Erkennungsziel auf der Bauteiloberseite an der Abbildungsposition abzubilden, und dann das Bauteil (19) am vorderen Ende des Bauteilzuführungsbandes (14) zur Bauteilaufnahmeposition zurückgeführt wird, um das Bauteil (19) mit der Saugdüse aufzunehmen.

7. Bauteilbestückungsmaschine (11) nach Anspruch 6, wobei in einem Fall, in dem die Bildverarbeitungsvorrichtung (41) nicht in der Lage ist, das Erkennungsziel auf der Bauteiloberseite zu erkennen, die Steuervorrichtung eine solche Steuerung durchführt, dass die Abbildungsposition geändert wird, das Bauteil (19) am vorderen Ende des Bauteilzuführungsbandes (14) der geänderten Abbildungsposition zugeführt wird und das Erkennungsziel auf der Bauteiloberseite erneut an der geänderten Abbildungsposition abgebildet wird, um eine Bildverarbeitung durchzuführen.

8. Bauteilbestückungsmaschine (11), die Folgendes umfasst:
einen Montagekopf (30), der so konfiguriert ist, dass er ein Bauteil (19), das von einer Bauteilversorgungsvorrichtung (13) zugeführt wird, auf einer Leiterplatte montiert;
eine Markierungsabbildungskamera (34), die vorgesehen ist, um sich integral mit dem Montagekopf (30) zu bewegen, und die konfiguriert ist, um eine Leiterplattenmarkierung der Leiterplatte abzubilden;
eine Bildverarbeitungsvorrichtung (41), die so konfiguriert ist, dass sie ein von der Markierungsbildkamera (34) aufgenommenes Bild verarbeitet; und
eine Beleuchtungsvorrichtung (51), die so konfiguriert ist, dass sie ein Erkennungsziel, das ein Zeichen, ein Symbol oder eine Markierung umfasst und an einer oberen Fläche des von der Komponentenzuführvorrichtung (13) zugeführten Bauteils (19) angebracht ist, von schräg oben beleuchtet, wenn das Erkennungsziel an einem oberen Ende einer Zuführvorrichtung (13) positioniert ist,
die Bauteilmontagemaschine (11) ist so konfiguriert, dass sie:
das Erkennungsziel auf der von der Beleuchtungseinrichtung (51) von schräg oben beleuchteten Bauteiloberseite von oben mit der Markenbildkamera (34) abzubilden, und
das Bild mit der Bildverarbeitungsvorrichtung (41) verarbeiten, um das Erkennungsziel zu erkennen,
wobei die Beleuchtungsvorrichtung (51) so vorgesehen ist, dass sie sich einstückig mit dem Montagekopf (30) bewegt, und einen Antriebsabschnitt (52) umfasst, der an dem Montagekopf angebracht und so konfiguriert ist, dass er:
die Beleuchtungseinrichtung (51) getrennt vom Montagekopf (30) zu bewegen oder zu drehen, und
wenn die Markierungsbildkamera (34) das Erkennungsziel auf der Bauteiloberseite abbildet, die Beleuchtungsvorrichtung (51) in eine Beleuchtungsposition zu bewegen oder zu drehen, in der das Erkennungsziel von schräg oben beleuchtet wird, und
wenn der Montagekopf (30) einen Vorgang zum Aufnehmen und Montieren eines Bauteils (19) durchführt, die Beleuchtungsvorrichtung (51) in eine zurückgezogene Position zu bewegen oder zu drehen, in der die Beleuchtungsvorrichtung (51) nicht mit einem in ihrer Nähe befindlichen Objekt oder einem montierten Bauteil (19) auf der Leiterplatte kollidiert.

9. Bauteilbestückungsmaschine (11) nach Anspruch 8, wobei die Bauteilzuführeinrichtung (13) eine Bandzuführeinrichtung ist, die an einem in der Bauteilbestückungsmaschine (11) vorgesehenen Zuführungseinstellabschnitt (12) angeordnet ist, und eine Positionsbeziehung zwischen der Beleuchtungsvorrichtung (51) und der Markierungsbildkamera (34) so konfiguriert ist, dass, wenn die Markierungsbildkamera (34) das Erkennungsziel auf der Bauteiloberseite an einer Abbildungsposition abbildet, die eine Position ist, die durch einen vorbestimmten Abstand in einer Bandzuführungsrichtung von einer Position getrennt ist, an der ein oberes Band (17) eines Bauteilzuführungsbandes (14), das in die auf dem Zuführungseinstellabschnitt (12) angeordnete Bandzuführung geladen ist, abgezogen wird, die Beleuchtungsvorrichtung (51) auf einer Seite der Bandvorschubrichtung von der Abbildungsposition aus positioniert ist, und das Erkennungsziel auf der oberen Oberfläche des Bauteils an der Abbildungsposition von schräg über der Seite der Bandvorschubrichtung beleuchtet wird.

10. Bauteilbestückungsmaschine (11) nach Anspruch 8 oder 9, wobei der Antriebsabschnitt (52) die Funktion hat, einen Beleuchtungswinkel der Beleuchtungsvorrichtung (51) in Bezug auf das Erkennungsziel auf der Bauteiloberfläche einzustellen.

11. Bauteilbestückungsmaschine (11) nach Anspruch 10, wobei in einem Fall, in dem die Bildverarbeitungseinrichtung (41) nicht in der Lage ist, das Erkennungsziel auf der Bauteiloberseite zu erkennen, der Antriebsabschnitt (52) den Beleuchtungswinkel der Beleuchtungseinrichtung (51) so ändert, dass das Erkennungsziel auf der Bauteiloberseite erneut abgebildet wird und eine Bildverarbeitung durchgeführt wird.

## Revendications

1. Machine de montage de composants (11) ayant une fonction de reconnaissance d'une cible de reconnaissance, comprenant un caractère, un symbole ou un repère, attaché à une surface supérieure d'un composant (19) approvisionné par un dispositif d'approvisionnement en composants (13), la machine de montage de composants (11) comprenant :
un dispositif d'éclairage (38) configuré pour éclairer la cible de reconnaissance sur la surface supérieure du composant (19) approvisionné par le dispositif d'approvisionnement en composants (13), quand la cible de reconnaissance est positionnée à une extrémité supérieure d'un dispositif d'alimentation (13), obliquement depuis le haut ;
une porte avant (24) positionnée au-dessus du dispositif d'alimentation (13), configurée pour ouvrir et fermer une section d'ouverture avant (23) dans la machine de montage de composants (11),
une caméra (34) configurée pour imager depuis le haut la cible de reconnaissance sur la surface supérieure du composant (19), qui est éclairée par le dispositif d'éclairage (38) obliquement depuis le haut ; et
un dispositif de traitement d'image (41) configuré pour traiter une image capturée par la caméra (34) afin de reconnaître la cible de reconnaissance,
dans laquelle le dispositif d'éclairage (38) est attaché à la porte avant (24).

2. Machine de montage de composants (11) selon la revendication 1, dans laquelle la caméra (34) est une caméra d'imagerie de repère configurée pour imager un repère de carte d'une carte de circuit sur laquelle le composant (19) est monté.

3. Machine de montage de composants (11) selon la revendication 1 ou 2, dans laquelle le dispositif d'approvisionnement en composants (13) est un dispositif d'alimentation de bande installé dans une section de réglage de dispositif d'alimentation (12) pourvue dans la machine de montage de composants (11), la porte avant (24) est positionnée au-dessus du dispositif d'alimentation de bande installé dans la section de réglage de dispositif d'alimentation (12), le dispositif d'éclairage (38) éclaire une cible de reconnaissance sur la surface supérieure du composant à la position d'imagerie, la position d'imagerie étant une position séparée d'une distance prédéterminée en direction d'alimentation de bande depuis une position où est pelée une bande supérieure (17) d'une bande d'approvisionnement en composants (14) chargée sur le dispositif d'alimentation de bande (13) installé dans la section de réglage de dispositif d'alimentation (12), et la caméra (34) image la cible de reconnaissance sur la surface supérieure du composant à la position d'imagerie.

4. Machine de montage de composants (11) selon la revendication 3, dans laquelle la position d'imagerie est positionnée d'un côté direction d'alimentation de bande à partir d'une position de saisie de composant où une buse d'aspiration saisit le composant (19) sur la bande d'approvisionnement en composants (14).

5. Machine de montage de composants (11) selon la revendication 4, dans laquelle la position d'imagerie est définie dans une tâche de production ou dans des données de composant de traitement d'image pour chaque type de composant dans la bande d'approvisionnement en composants (14).

6. Machine de montage de composants (11) selon la revendication 4 ou 5, dans laquelle, dans le cas d'une reconnaissance de la cible de reconnaissance sur la surface supérieure du composant dans la bande d'approvisionnement en composants (14), un dispositif de contrôle configuré pour contrôler une opération d'alimentation de bande de la bande d'approvisionnement en composants (14) du dispositif d'alimentation de bande (13) met en œuvre un contrôle de telle sorte que le composant (19) à une extrémité avant de la bande d'approvisionnement en composants (14) est alimenté à la position d'imagerie pour imager la cible de reconnaissance sur la surface supérieure du composant à la position d'imagerie, et ensuite le composant (19) à l'extrémité avant de la bande d'approvisionnement en composants (14) est ramené à la position de saisie de composant pour saisir le composant (19) avec la buse d'aspiration.

7. Machine de montage de composants (11) selon la revendication 6, dans laquelle, dans le cas où le dispositif de traitement d'image (41) n'est pas capable de reconnaître la cible de reconnaissance sur la surface supérieure du composant, le dispositif de contrôle met en œuvre un contrôle de telle sorte que la position d'imagerie est changée, le composant (19) à l'extrémité avant de la bande d'approvisionnement en composants (14) est alimenté à la position d'imagerie changée, et la cible de reconnaissance sur la surface supérieure du composant est à nouveau imagée à la position d'imagerie changée pour mettre en œuvre un traitement d'image.

8. Machine de montage de composants (11), comprenant :
une tête de montage (30) configurée pour monter un composant (19) approvisionné par un dispositif d'approvisionnement en composants (13) sur une carte de circuit ;
une caméra d'imagerie de repère (34) pourvue pour se déplacer conjointement avec la tête de montage (30) et configurée pour imager un repère de carte de la carte de circuit ;
un dispositif de traitement d'image (41) configuré pour traiter une image capturée par la caméra d'imagerie de repère (34) ; et
un dispositif d'éclairage (51) configuré pour éclairer une cible de reconnaissance, comprenant un caractère, un symbole ou un repère, attaché à une surface supérieure du composant (19) approvisionné par le dispositif d'approvisionnement en composants (13), quand la cible de reconnaissance est positionnée à une extrémité supérieure d'un dispositif d'alimentation (13), obliquement depuis le haut,
la machine de montage de composants (11) étant configurée pour :
imager depuis le haut la cible de reconnaissance sur la surface supérieure du composant, qui est éclairée par le dispositif d'éclairage (51) obliquement depuis le haut, avec la caméra d'imagerie de repère (34), et
traiter l'image avec le dispositif de traitement d'image (41) pour reconnaître la cible de reconnaissance,
dans laquelle le dispositif d'éclairage (51) est pourvu pour se déplacer conjointement avec la tête de montage (30) et comprend une section d'entraînement (52) attachée à la tête de montage (30) et est configuré pour :
déplacer ou faire pivoter le dispositif d'éclairage (51) séparément de la tête de montage (30), et
quand la caméra d'imagerie de repère (34) image la cible de reconnaissance sur la surface supérieure du composant, déplacer ou faire pivoter le dispositif d'éclairage (51) jusqu'à une position d'éclairage où la cible de reconnaissance est éclairée obliquement depuis le haut, et
quand la tête de montage (30) met en œuvre une opération de saisie et de montage de composant (19), déplacer ou faire pivoter le dispositif d'éclairage (51) jusqu'à une position rétractée où le dispositif d'éclairage (51) n'interfère pas avec un objet existant à proximité de celui-ci ou avec un composant monté (19) sur la carte de circuit.

9. Machine de montage de composants (11) selon la revendication 8, dans laquelle le dispositif d'approvisionnement en composants (13) est un dispositif d'alimentation de bande installé dans une section de réglage de dispositif d'alimentation (12) pourvue dans la machine de montage de composants (11), et une relation de position entre le dispositif d'éclairage (51) et la caméra d'imagerie de repère (34) est configurée de telle sorte que quand la caméra d'imagerie de repère (34) image la cible de reconnaissance sur la surface supérieure du composant à une position d'imagerie qui est une position séparée d'une distance prédéterminée dans une direction d'alimentation de bande d'une position où est pelée une bande supérieure (17) d'une bande d'approvisionnement en composants (14) chargée sur le dispositif d'alimentation de bande installé dans la section de réglage de dispositif d'alimentation (12), le dispositif d'éclairage (51) est positionné d'un côté direction d'alimentation de bande depuis la position d'imagerie, et la cible de reconnaissance sur la surface supérieure du composant à la position d'imagerie est éclairée obliquement depuis le haut du côté direction d'alimentation de bande.

10. Machine de montage de composants (11) selon la revendication 8 ou 9, dans laquelle la section d'entraînement (52) a pour fonction de réguler un angle d'éclairage du dispositif d'éclairage (51) par rapport à la cible de reconnaissance sur la surface supérieure du composant.

11. Machine de montage de composants (11) selon la revendication 10, dans laquelle, dans le cas où le dispositif de traitement d'image (41) n'est pas capable de reconnaître la cible de reconnaissance sur la surface supérieure du composant, la section d'entraînement (52) change l'angle d'éclairage du dispositif d'éclairage (51) de telle sorte que la cible de reconnaissance sur la surface supérieure du composant soit à nouveau imagée et qu'un traitement d'image soit mis en œuvre.
